# EUROPEAN PATENT APPLICATION

(11) **EP 3 637 973 A1**
(43) Date of publication of application: **15.04.2020**
(21) Application number: 18813310.2
(22) Date of filing: 06.06.2018
(51) Int. Cl.: H05K 13/04, H05K 13/08, B25J 13/00

(54) **LEAD WIRE INSERTING METHOD AND HOLDING DEVICE FOR IMPLEMENTING SAME**

(30) Priority: 06.06.2017 JP 2017111399
(71) Applicant: Kawasaki Jukogyo Kabushiki Kaisha, Kobe-shi, Hyogo 650-8670 (JP)
(72) Inventor: HASHIMOTO, Yasuhiko, Hyogo 6508670 (JP); BANDO, Kenji, Hyogo 6508670 (JP); KIMURA, Toshimitsu, Hyogo 6508670 (JP)
(74) Representative: Luten, Martin Haaije
(86) International application number: PCT/JP2018/021680
(87) International publication number: WO 2018/225777

(57) **Abstract**

A lead wire insertion method for inserting a lead wire of an electronic component E with a lead wire into a through hole 98 formed in the wiring board 90 includes a third step of placing a jig 80 on the wiring board 90 so that one side surface of the jig 80 faces the another electronic component E', and a bottom side end of an inner wall of a guide hole 88 of the jig 80 is fitted to a through hole 98 formed in the wiring board 90, in which the guide hole 88 is opened and formed in the one side surface of the jig 80 so that a cross-sectional area becomes smaller from a top surface to a bottom surface.

## Description

### Technical Field

The present invention relates to a lead wire insertion method and a holding device used for carrying out the method.

### Background Art

Conventionally, a lead wire insertion method for inserting a lead wire of an electronic component with a lead wire into a through hole formed in a wiring board has been known. Moreover, a jig used for carrying out the method has been known. An example of such a jig is an electronic component fixing jig described in Patent Literature 1.

The electronic component fixing jig of Patent Literature 1 includes a plurality of divided members that are detachable from each other. These dividing members are each provided with a groove over both upper and lower end surfaces, and holes are formed so that the grooves face each other in a state where the dividing members are combined with each other. These holes have a conical shape, and one side opening is formed larger than the other side opening.

### Citation List

### Patent Literature

PTL 1: JP 2002-198696 A

### Summary of Invention

### Technical Problem

Incidentally, in the electronic component fixing jig described in Patent Literature 1, there is a problem that, in a case where another electronic component is mounted adjacent to a location where the electronic component with a lead wire is mounted (that is, a case where a plurality of electronic components are mounted on the wiring board in a densely packed state), it is difficult to insert the lead wire of the electronic component with a lead wire into the through hole by being obstructed by the another electronic component.

Therefore, the present invention has an object to provide a lead wire insertion method which allows a lead wire of an electronic component with a lead wire to be smoothly inserted into a through hole even when a plurality of electronic components are mounted on a wiring board in a densely packed state, and a jig used for carrying out the method.

### Solution to Problem

In order to solve the above-described problem, according to the present invention, there is provided a lead wire insertion method for inserting a lead wire of an electronic component with a lead wire into a through hole formed in a wiring board, the method including: a first step of preparing the electronic component with a lead wire, the wiring board configured so that another electronic component is mounted adjacent to a location where the electronic component with a lead wire is mounted, and a jig having a guide hole for guiding the lead wire to the through hole; a second step of holding the electronic component with a lead wire; a third step of placing the jig on the wire board so that one side surface of the jig faces the another electronic component, and a bottom side end of an inner wall of the guide hole of the jig is fitted to the through hole formed in the wiring board; and a fourth step of causing a leading end of the lead wire to be brought into abutment against the inner wall of the guide hole and to be slid toward the wiring board, and guiding the lead wire of the electronic component with a lead wire to be inserted into the through hole, in which the guide hole is opened and formed in the one side surface of the jig so that a cross-sectional area becomes smaller from a top surface to a bottom surface.

According to this configuration, the guide hole formed in the jig is opened and drilled in the one side surface of the jig. Therefore, even if another electronic component is mounted adjacent to the one side surface, the third step of placing the jig on the wiring board can be performed without being obstructed by the another electronic component. Therefore, the lead wire insertion method according to the present invention can smoothly insert the lead wire of the electronic component with a lead wire into the through hole even when the plurality of electronic components are mounted on the wiring board in a densely packed state.

In the first step, a robot that performs an operation on the electronic component with a lead wire and the jig may further be prepared, and the robot may include: a first robot arm; a first end effector that is attached to the first robot arm and performs the second step and the fourth step by performing an operation while holding the electronic component with the lead wire; a second robot arm; and a second end effector that is attached to the second robot arm and performs the third step by performing an operation while holding the jig.

According to this configuration, by using the robot, the lead wire insertion method according to the present invention can be carried out efficiently without requiring a manual operation.

The first end effector may include a holding device that is rotatably provided at a base thereof and holds the electronic component with a lead wire, the holding device may include a plurality of holding units that each hold one electronic component with a lead wire and are provided radially at intervals in a circumferential direction, in the first step, a plurality of electronic components with lead wires may be prepared, in the second step, each of the plurality of holding units may be caused to hold a corresponding one of the plurality of electronic components with lead wires, while rotating the holding device, so that the electronic components with lead wires are held, in the fourth step, the lead wire of the electronic component with a lead wire may be guided and inserted into the through hole, the electronic component with a lead wire being held so as to face the wiring board, after the fourth step is performed, the third step of placing the jig on the wire board so that the one side surface of the jig faces the another electronic component or the electronic component with a lead wire on which the fourth step has been already performed, and the bottom side end of the inner wall of the guide hole of the jig is fitted to a next through hole formed in the wiring board may be performed again, and the fourth step of guiding a next electronic component with a lead wire among the plurality of electronic components with lead wires and inserting it into the through hole after the holding device is rotated again so that the next electronic component with a lead wire faces the wiring board may be performed again, and the third step may be performed again and the fourth step may be performed again, which is repeated, so that the operation of guiding the lead wire of the electronic component with a lead wire and inserting it into the through hole are repeatedly performed.

According to this configuration, the operation of guiding the lead wire of the electronic component with a lead wire and inserting it into the through hole can be repeatedly performed in a short time. As a result, the lead wire insertion method according to the present invention can be carried out more efficiently without requiring a manual operation.

The holding device may further include detector for detecting whether or not there is an abnormality in each lead wire of the electronic component with a lead wire.

According to this configuration, when there is an abnormality in the lead wire, it can be detected using the detector. Therefore, for example, the mounting of the electronic component with a lead wire in which an abnormality in the lead wire such as a bend or a defect is detected is canceled, or a location against which the leading end of the lead wire is brought into abutment (a part of the inner wall of the guide hole) is shifted according to the bend or the defect, so that the lead wire in which an abnormality has occurred can be inserted into the through hole.

The detector may include: a light projector that is provided at a base of the first end effector, and emits a light beam onto the lead wire of the electronic component with a lead wire when the holding unit and the electronic component with a lead wire held thereby rotate; and a light receiver that is provided at the base of the first end effector so as to face the light projector through the holding unit and the electronic component with a lead wire held thereby, and receives the light beam emitted from the light projector.

According to this configuration, the operation of guiding the lead wire of the electronic component with a lead wire and inserting it into the through hole can be repeatedly performed in a short time, and at the same time, whether or not there is an abnormality in the lead wire of each electronic component with a lead wire can be detected.

In order to solve the above-described problem, according to the present invention, there is provided a holding device for holding the electronic component with a lead wire, which is used for carrying out the lead wire insertion method described above and is included in the first end effector, in which the holding device is rotatably provided at a base of the first end effector, in which the holding device includes a plurality of holding units that each hold one electronic component with a lead wire and are provided radially at intervals in a circumferential direction, in which, in the first step, the holding device prepares a plurality of electronic components with lead wires, in which, in the second step, the holding device causes each of the plurality of holding units to hold a corresponding one of the plurality of electronic components with lead wires, while rotating, so that the electronic components with lead wires prepared in the first step are held, in which, in the fourth step, the holding device guides the lead wire of the electronic component with a lead wire to be inserted into the through hole, the electronic component with a lead wire being held so as to face the wiring board, in which, after performing the fourth step, the holding device performs again the third step of placing the jig on the wire board so that the one side surface of the jig faces the another electronic component or the electronic component with a lead wire on which the fourth step has been already performed, and the bottom side end of the inner wall of the guide hole of the jig is fitted to a next through hole formed in the wiring board, and performs again the fourth step of guiding a next electronic component with a lead wire among the plurality of electronic components with lead wires and inserting it into the through hole after the holding device rotates again so that the next electronic component with a lead wire faces the wiring board, and in which the holding device performs again the third step and the fourth step, and repeats these, so that the operation of guiding the lead wire of the electronic component with a lead wire and inserting it into the through hole are repeatedly performed.

According to this configuration, the operation of guiding the lead wire of the electronic component with a lead wire and inserting it into the through hole can be repeatedly performed in a short time. As a result, it is possible to provide the holding device used for carrying out the lead wire insertion method according to the present invention more efficiently without requiring a manual operation.

The holding device may further include detector for detecting whether or not there is an abnormality in each lead wire of the electronic component with a lead wire.

According to this configuration, when there is an abnormality in the lead wire, it can be detected using the detector. Therefore, for example, the mounting of the electronic component with a lead wire in which an abnormality in the lead wire such as a bend or a defect is detected is canceled, or a location against which the leading end of the lead wire is brought into abutment (a part of the inner wall of the guide hole) is shifted according to the bend or the defect, so that the lead wire in which an abnormality has occurred can be inserted into the through hole.

The detector may include: a light projector that is provided at a base of the first end effector, and emits a light beam onto the lead wire of the electronic component with a lead wire when the holding unit and the electronic component with a lead wire held thereby rotate; and a light receiver that is provided at the base of the first end effector so as to face the light projector through the holding unit and the electronic component with a lead wire held thereby, and receives the light beam emitted from the light projector.

According to this configuration, the operation of guiding the lead wire of the electronic component with a lead wire and inserting it into the through hole can be repeatedly performed in a short time, and at the same time, whether or not there is an abnormality in the lead wire of each electronic component with a lead wire can be detected.

### Advantageous Effects of Invention

According to the present invention, it is possible to provide the lead wire insertion method which allows the lead wire of the electronic component with a lead wire to be smoothly inserted into the through hole even when the plurality of electronic components are mounted on the wiring board in a densely packed state, and the holding device used for carrying out the method.

### Brief Description of Drawings

Fig. 1 is a view showing a schematic configuration of a robot used for carrying out a lead wire insertion method according to an embodiment of the present invention.
Fig. 2 is a view showing a state in which a plurality of electronic components with lead wires are held by a holding device provided in the robot.
Fig. 3 is a side view for explaining a case where the presence or absence of an abnormality of a lead wire is detected by detector used for carrying out the lead wire insertion method according to the embodiment of the present invention.
Figs. 4 are bottom views for explaining a case where the detector detects the presence or absence of an abnormality in the lead wire, in which Fig. 4(a) is a view when a first light beam is emitted to a first lead wire, and Fig. 4(b) is a view when a second light beam is emitted to a second lead wire.
Fig. 5 is an external perspective view of a jig used for carrying out the lead wire insertion method according to the embodiment of the present invention.
Fig. 6 is an enlarged perspective view of guide holes of the jig and the vicinity thereof.
Fig. 7 is a schematic view for explaining a third step and a fourth step of the lead wire insertion method according to the embodiment of the present invention.
Fig. 8 is a side view for explaining a case where the presence or absence of an abnormality of the lead wire is detected by the detector used for carrying out the lead wire insertion method according to a modification of the present invention.
Figs. 9 are bottom views for explaining a case where the detector detects the presence or absence of an abnormality in the lead wire, in which Fig. 9(a) is a view when a first light beam is emitted to a first lead wire, Fig. 9(b) is a view when a second light beam is emitted to a second lead wire, Fig. 9(c) is a view when a third light beam is emitted to a third lead wire, and Fig. 9(d) is a view when a fourth light beam is emitted to a fourth lead wire.

### Description of Embodiments

Hereinafter, a lead wire insertion method and a holding device used for the implementation according to an embodiment of the present invention will be described with reference to the drawings. In addition, the present invention is not limited by this embodiment. Note that, in the followings, the same or corresponding elements are denoted by the same reference symbols throughout all the drawings, and redundant description thereof is omitted.

### (Robot 11)

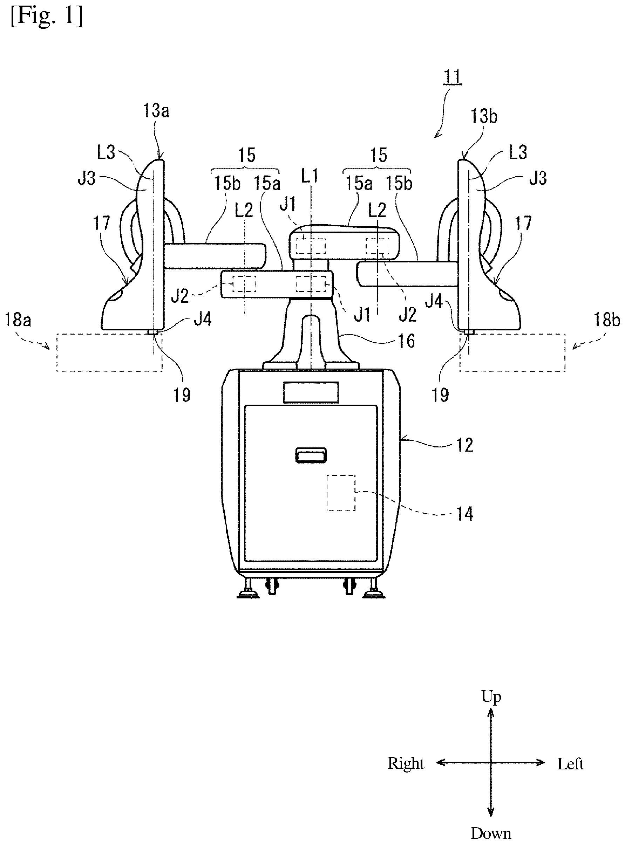

Fig. 1 is a view showing a schematic configuration of a robot used for carrying out a lead wire insertion method according to an embodiment of the present invention. As shown in Fig. 1, a robot 11 used for carrying out the lead wire insertion method according to the present embodiment includes a base 12 fixed to a carriage, a pair of robot arms 13a and 13b (first robot arm 13a and second robot arm 13b) supported by the base 12, and a control device 14 housed in the base 12. The robot 11 can be installed in a limited space (for example, 610 mm × 620 mm) corresponding to one person.

Hereinafter, the direction in which the pair of robot arms is expanded is referred to as the left-right direction, the direction parallel to the axial center of the base shaft is referred to as the up-down direction, and the direction orthogonal to the left-right direction and the up-down direction is referred to as the front-rear direction. The robot 11 of this embodiment is applied to a wiring board mounting site, and performs an operation of mounting electronic components with lead wires on the wiring board.

### (Pair of robot arms 13a and 13b)

The first robot arm 13a (robot arm on the right in the figure) and the second robot arm 13b (robot arm on the left in the figure) are each a horizontal articulated robot arm configured to be movable with respect to the base 12. The first robot arm 13a includes an arm unit 15, a wrist unit 17, and a first end effector 18a. The second robot arm 13b includes an arm unit 15, a wrist unit 17, and a second end effector 18b. Note that the pair of robot arms 13a and 13b can operate independently or operate in association with each other.

In this example, the arm unit 15 includes a first link 15a and a second link 15b. The first link 15a is connected to a base shaft 16 fixed to the upper surface of the base 12 by a rotary joint J1, and can turn around a rotation axis L1 passing through the axial center of the base shaft 16. The second link 15b is connected to the leading end of the first link 15a by a rotary joint J2, and can turn around a rotation axis L2 defined at the leading end of the first link 15a.

The wrist unit 17 has a mechanical interface 19 to which the first end effector 18a or the second end effector 18b is attached, and is connected to the leading end of the second link 15b via a linear motion joint J3 and a rotary joint J4. The wrist unit 17 can be moved up and down with respect to the second link 15b by the linear motion joint J3. The wrist unit 17 can turn around a rotation axis L3 perpendicular to the second link 15b by the rotary joint J4.

The first end effector 18a is connected to the mechanical interface 19 of the right wrist unit 17. That is, the first end effector 18a is provided at the leading end of the first robot arm 13a. Similarly, the second end effector 18b is connected to the mechanical interface 19 of the left wrist unit 17. That is, the second end effector 18b is provided at the leading end of the second robot arm 13b.

The pair of robot arms 13a and 13b configured as described above each has joints J1 to J4. Further, the pair of robot arms 13a and 13b each includes a servomotor for driving (not shown) and an encoder (not shown) for detecting the rotation angle of the servomotor so as to correspond to the joints J1 to J4. Further, the rotation axis L1 of the first link 15a of the first robot arm 13a and the rotation axis L1 of the first link 15a of the second bot arm 13b are on the same straight line, and the first link 15a of the first robot arm 13a and the first link 15a of the second robot arm 13b are arranged with a vertical difference in height.

### (First end effector 18a)

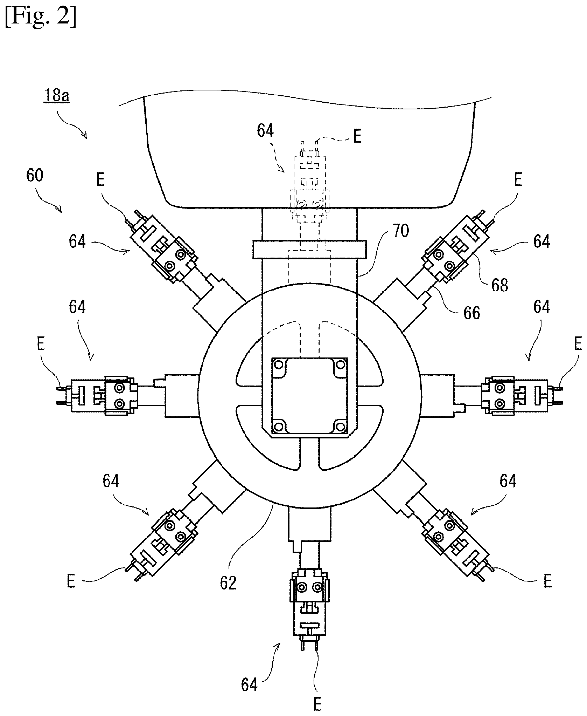

The first end effector 18a will be described with reference to Fig. 2. Fig. 2 is a view showing a state in which a holding device provided in a robot used for carrying out the lead wire insertion method according to the embodiment of the present invention is caused to hold a plurality of electronic components with lead wires.

The first end effector 18a includes a holding device 60 that is rotatably provided at a base thereof and holds electronic components E with lead wires, and a connection portion 70 that connects the holding device 60 and the wrist unit 17.

Conventionally, holding devices for holding an electronic component with a lead wire, which are used for carrying out a lead wire insertion method, have been known. As such a holding device, for example, there is a holding device for an electronic component described in JP 2000-94238 A.

In the holding device of the above-mentioned prior art, first, a holder is guided by a guide by a driving source to perform a direct connection motion. At this time, guide claws approach each other, and one guide claw sinks into a lower surface of the other guide claw, and a lead wire of an electronic component is guided into a groove of the guide claw. At this time, the processing device is lowered simultaneously, so that the guide claw is lowered through a slider while guiding the lead wire of the electronic component into the groove of the guide claw, and the operation of inserting the lead wire of the electronic component into a lead wire escape hole of a processing jig is completed.

Incidentally, the holding device of the prior art has a problem that it takes time to perform an operation of inserting the lead wire. In particular, the problem can be prominent when a plurality of electronic components are mounted on a wiring board in a densely packed state as in the present embodiment. In addition, in the holding device of the above-mentioned prior art, insertion is not performed according to an abnormality that differs for each lead wire, and thus, there is also a problem that the lead wire cannot be reliably inserted.

Therefore, the holding device according to the present embodiment is configured so that the lead wire of the electronic component with a lead wire can be smoothly and reliably inserted into the through hole.

The holding device 60 includes a plurality of holding units 68 that each hold one electronic component E with a lead wire and are provided radially at intervals in the circumferential direction. Specifically, the holding device 60 includes a disc member 62 whose center portion is rotatably provided at the lower end (base) of the connection portion 70, eight holding mechanisms 64 connected to the disc member 62 at equal intervals in the circumferential direction of the disc member 62 as to extend radially along the radial direction, and the holding units 68 provided at the leading ends of the eight holding mechanisms 64, respectively.

The eight holding mechanisms 64 each hold one electronic component E with a lead wire for an operation. The eight holding mechanisms 64 have the same structure having a longitudinal dimension. Therefore, in Fig. 2, in order to avoid the complexity of appearance, only the holding mechanism 64 positioned at the upper right in the figure is given reference numerals in detail, and reference numerals of the other seven holding mechanisms 64 are appropriately omitted. The eight holding mechanisms 64 each include a radially extending portion 66 that extends along the radial direction of the disc member 62, and the holding unit 68 that is provided at the leading end of the radially extending portion 66. The holding unit 68 according to the present embodiment holds the electronic component E with a lead wire by restraining (chucking) it from both sides. However, the present invention is not limited to this, and the eight holding units 68 may each hold the electronic component E with a lead wire in other modes, such as holding by suction using negative pressure.

### (Detector 100)

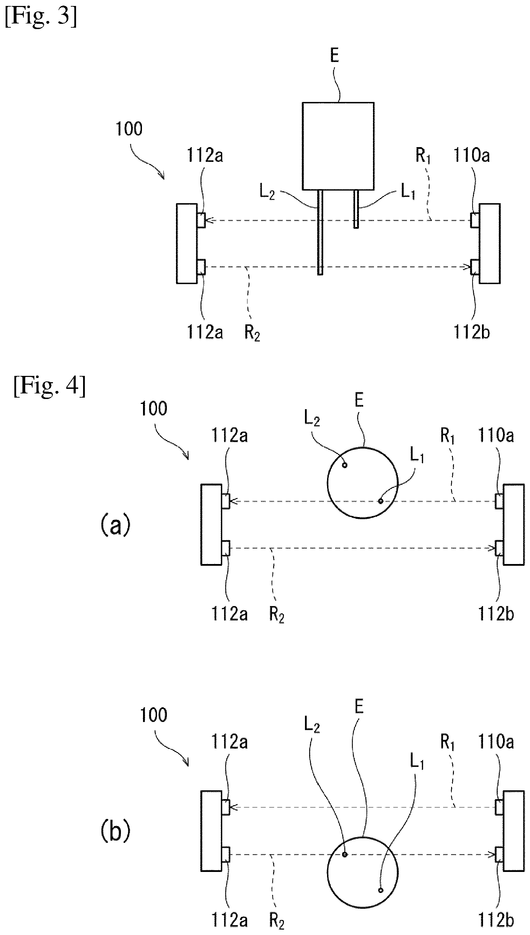

With reference to Figs. 3 and 4, detector 100 provided in the holding device 60 will be described. The holding device 60 may include the detector 100 for detecting whether or not there is an abnormality in each lead wire of the plurality of electronic components E with lead wires.

Fig. 3 is a side view for explaining a case where the presence or absence of an abnormality of the lead wire is detected by the detector used for carrying out the lead wire insertion method according to the embodiment of the present invention. Figs. 4 are bottom views for explaining a case where the detector detects the presence or absence of an abnormality in the lead wire, in which Fig. 4(a) is a view when a first light beam is emitted to a first lead wire, and Fig. 4(b) is a view when a second light beam is emitted to a second lead wire.

The detector 100 detects the presence or absence of an abnormality such as a bend or a defect of two lead wires L₁ and L₂ having different axial dimensions (the shorter one is the lead wire L₁ and the longer one is the lead wire L₂ in the figure). The detector 100 includes light projectors 110a and 110b that are provided at the base of the first end effector 18a, and emit light beams R₁ and R₂ onto the lead wire of the electronic component E with a lead wire when the holding unit 68 and the electronic component E with a lead wire held thereby rotate, and light receivers 112a and 112b that are provided at the base of the first end effector 18a so as to face the light projectors 110a and 110b through the holding unit 68 and the electronic component E with a lead wire held thereby, and receive the light beams R₁ and R₂ emitted from the light projectors 110a and 110b. Specifically, the detector 100 includes the first light projector 110a that emits the first light beam R₁ indicated by the broken line arrow in the figure onto the leading end of one lead wire L₁ of the two lead wires L₁ and L₂ in the normal state, the first light receiver 112a that receives the first light beam R₁ emitted from the first light projector 110a, the second light projector 110b that emits the second light beam R₂ indicated by the broken line arrow in the figure onto the leading end of the another lead wire L₂ of the two lead wires L₁ and L₂ in the normal state, and the second light receiver 112b that receives the second light beam R₂ emitted from the second light projector 110b.

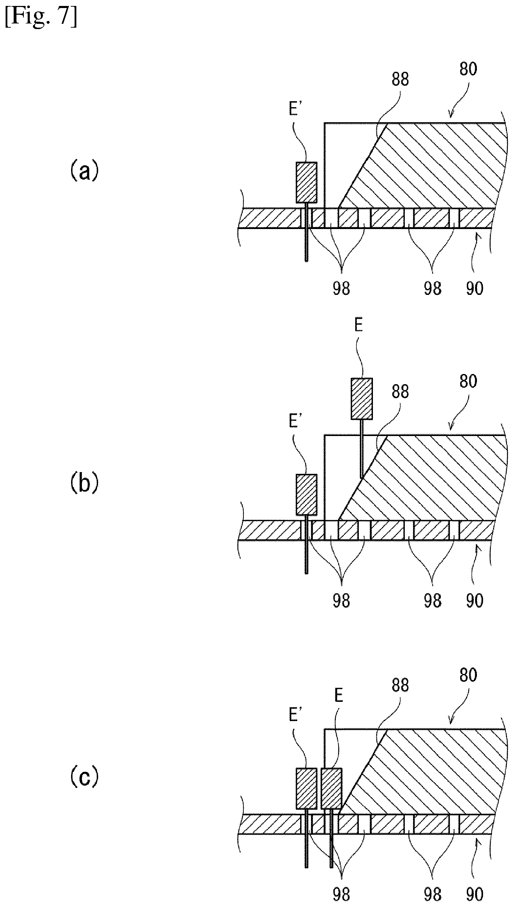

Preferably, as shown in Figs. 7, when the electronic component E with a lead wire passing through the detector 100 is viewed from the bottom, a straight line connecting the root portion of one lead wire L₁ and the root portion of the another lead wire L₂ is not parallel to the first light beam R₁ and the second light beam R₂. More preferably, when the electronic component E with a lead wire is viewed from the bottom, the straight line connecting the root portion of one lead wire L₁ and the root portion of the another lead wire L₂ is inclined by about 45 ° with respect to the first light beam R₁ and the second light beam R₂. As a result, the timings at which the one lead wire L₁ and the another lead wire L₂ block the first light beam R₁ are not the same, and the timings at which the one lead wire L₁ and the another lead wire L₂ block the second light beam R₂ are not the same. As a result, it is possible to improve the accuracy of detecting an abnormality of a lead wire.

Here, for example, the illustration thereof is omitted in Fig. 2 in order to avoid the complexity of appearance, but the first light projector 110a and the second light receiver 112b are provided on the near side of the holding mechanism 64, and the second light projector 110b and the first light receiver 112a are provided on the far side of the holding mechanism 64, so that the first light beam R₁ may be projected in the direction from the near side to the far side, and the second light beam R₂ may be projected in the direction from the far side to the near side.

In the present embodiment, when the holding device 60 rotates by 45 °, in any one of the eight electronic components E with lead wires held by the holding device 60, one lead wire L₁ is moved so as to block the first light beam R₁, and the another lead wire L₂ is moved so as to block the second light beam R₂. Then, the detector 100 detects the presence or absence of abnormalities of the two leads lines L₁ and L₂ based on the change in the amount of received light of the first light beam R₁ and the second light beam R₂ received by the first light receiver 112a and the second light receiver 112b, respectively.

### (Jig 80)

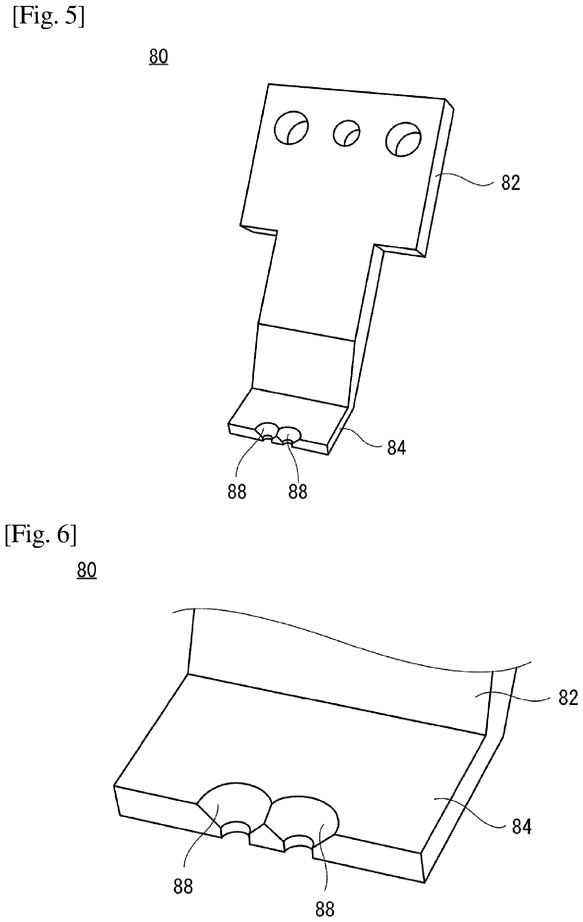

Furthermore, a jig attached to the second end effector 18b will be described with reference to Figs. 5 and 6. Fig. 5 is an external perspective view of the jig used for carrying out the lead wire insertion method according to the embodiment of the present invention. Fig. 6 is an enlarged perspective view of guide holes of the jig and the vicinity thereof.

The jig 80 according to this embodiment includes a mounting portion 82 to be attached to the second end effector 18b, and a placing portion 84 which is bent from the lower end of the mounting portion 82 and extends substantially to the near side in Figs. 3 and 4 to be formed in a substantially flat-plate shape. In the side surface of the placing portion 84 which is positioned substantially on the near side in Figs. 3 and 4 and the vicinity thereof, there are formed two guide holes 88 for guiding the lead wires of the electronic component E with lead wires to the through holes of the wiring board. Each of the two guide holes 88 is opened and formed in the side surface (one side surface of the jig) of the placing portion 84 which is positioned substantially on the near side in Figs. 3 and 4 so that the cross-sectional area becomes smaller from the top surface to the bottom surface.

### (Lead wire insertion method)

An example of the lead wire insertion method according to the embodiment of the present invention will be described mainly with reference to Fig. 7. Fig. 7 is a schematic view for explaining a third step and a fourth step of the lead wire insertion method according to the embodiment of the present invention. In Fig. 7, in order to avoid the complexity of appearance, the illustration of the holding device that holds the electronic component E with a lead wire for an operation is omitted.

First, the plurality of electronic components E with lead wires, a wiring board 90 configured so that another electronic component E' is mounted adjacent to a location where the electronic component E with a lead wire is mounted, the jig 80 having the guide holes 88 for guiding the lead wires to through holes 98 formed in the wiring board 90, and a robot 11 that performs an operation on the electronic components E with lead wires and the jig 80 are prepared. Note that the first end effector 18a of the robot 11 includes the holding device 60 for holding the electronic component E with a lead wire, which is rotatably provided at the base thereof. In the present embodiment, a first step is performed in this way.

Next, each of the plurality of holding units 68 is caused to hold a corresponding one of the plurality of electronic components E with lead wires, while rotating the holding device 60, so that the electronic components E with lead wires are held. Specifically, the holding device 60 is moved to a space above the installation space in which the plurality of electronic components E with lead wires are prepared. Then, the holding device 60 is lowered from there, and the holding unit 68 of one holding mechanism 64 which extends downward among the eight holding mechanisms 64 is caused to hold one electronic component E with a lead wire. Thereafter, the holding device 60 is rotated by 45 ° so that a holding mechanism 64 other than the above holding mechanism 64 is set to extend downward, and the other holding mechanism 64 is caused to hold one electronic component E with a lead wire. By repeating this, the holding device 60 is caused to hold the plurality of electronic components E with lead wires. In the present embodiment, a second step of holding the electronic components E with lead wires is performed in this way. Note that the detector 100 may detect the presence or absence of an abnormality in the lead wire by the rotating operation of the holding device 60 at this time.

Further, as shown in Fig. 5(a), the second end effector 18b causes the jig 80 to be placed on the wiring board 90 so that one side surface of the jig 80 faces the another electronic component E', and the bottom side end of the inner wall of the guide hole 88 of the jig 80 is fitted to the through hole 98 formed in the wiring board 90.

### The third step is performed in this way.

Then, as shown in Fig. 5(b), the first end effector 18a causes the leading end of the lead wire to be brought into abutment against the inner wall of the guide hole 88 and to be slid toward the wiring board 90, and as shown in Fig. 5(c), the lead wire is guided and inserted into the through hole 88. The fourth step is performed in this way.

As described above, one electronic component E with a lead wire can be inserted into the through hole 98 formed in the wiring board 90.

Furthermore, after the fourth step is performed, the third step of placing the jig 80 on the wire board 90 so that one side surface of the jig 80 faces the another electronic component E' or the electronic component E with a lead wire on which the fourth step has been already performed, and the bottom side end of the inner wall of the guide hole 88 of the jig 80 is fitted to a next through hole 98 formed in the wiring board 90 is performed again, and the fourth step of guiding a next electronic component E with a lead wire among the plurality of electronic components E with lead wires and inserting it into the through hole 98 after the holding device 60 is rotated again so that the next electronic component E with a lead wire faces the wiring board 90 is performed again. As described above, after the plurality of electronic components E with lead wires E are held by the holding device 60, the third step is performed again and the fourth step is performed again, which is repeated, so that the operation of guiding the lead wire of the electronic component E with a lead wire and inserting it into the through hole 98 can be repeatedly performed.

Specifically, first, after the first electronic component E with a lead wire is inserted into the through hole 98 (that is, after the state shown in Fig. 5(C) is made), the electronic component E with a lead wire is released from the holding unit 68. Next, after the holding unit 68 is separated from the wiring board 90, the holding device 60 is rotated again so that the next electronic component E with a lead wire faces the wiring board 90. Note that the detector 100 may detect the presence or absence of an abnormality in the lead wire by the rotating operation of the holding device 60 at this time. Further, in conjunction with the rotation, the holding device 60 and the seven electronic components E with lead wires held by the holding device 60, and the second end effector 18b and the jig 80 held by the second end effector 18b are moved to the right side in Fig. 5(c). Then, the jig 80 is placed on the wiring board 90 so that one side surface of the jig 80 faces the first electronic component E with a lead wire, and the bottom side end of the inner wall of the guide hole 88 is fitted to the through hole 98 formed to be adjacent to the electronic component E with a lead wire illustrated in Fig. 5(c) on the right side. The third step is performed again in this way. The subsequent procedure is the same as that for inserting the first electronic component E with a lead wire into the through hole 98, and the description thereof will not be repeated.

By repeating the above procedures, the operation of guiding the lead wire of the electronic component E with a lead wire and inserting it into the through hole 98 can be repeatedly performed using the robot 11.

Further, the holding device 60 for holding the electronic component E with a lead wire, which is used for carrying out the above-described lead wire insertion method, includes the holding units 68 for holding the electronic components E with lead wires at the respective leading ends of the eight holding mechanisms 68. After the holding device 60 holds the plurality of electronic component E with lead wires while rotating in the second step of holding the electronic component E with a lead wire, the third step is performed by the second end effector. Then, the fourth step is performed on the electronic component E with a lead wire held so as to face the wiring board 90. After the fourth step is performed, the holding device 60 rotates again so that the next electronic component E with a lead wire among the plurality of electronic components E with lead wires face the wiring board 90, and the third step and the fourth step are performed again. By repeating this, the operation of guiding the lead wire of the electronic component E with a lead wire and inserting it into the through hole 98 is repeatedly performed.

### (Effect)

In the lead wire insertion method according to the present embodiment, the guide holes 88 formed in the jig 80 are opened and drilled in one side surface of the jig 80. Therefore, even if the another electronic component E' is mounted adjacent to the one side surface, the third step of placing the jig 80 on the wiring board 90 can be performed without being obstructed by the another electronic component E'. Therefore, in the lead wire insertion method according to the present invention, the lead wire of the electronic component E with a lead wire can be smoothly inserted into the through hole 98 even when the plurality of electronic components E (and other electronic components E') are mounted on the wiring board 90 in a densely packed state.

Further, in the lead wire insertion method according to the present embodiment, in the first step, the robot 11 that performs an operation on the electronic component E with a lead wire and the jig 80 is further prepared, and the second to fourth steps are performed using the robot 11. With this, the lead wire insertion method according to the present embodiment can be carried out efficiently without requiring a manual operation.

Furthermore, in the present embodiment, by the holding device 60 of the first end effector 18a, the operation of guiding the lead wire of the electronic component E with a lead wire and inserting it into the through hole 98 can be repeatedly performed in a short time. As a result, the lead wire insertion method according to the present invention can be carried out more efficiently without requiring a manual operation.

In the present embodiment, when there is an abnormality in the lead wire, it can be detected using the detector 100. Therefore, for example, the mounting of the electronic component E with a lead wire in which an abnormality in the lead wire such as a bend or a defect is detected is canceled, or a location against which the leading end of the lead wire is brought into abutment (a part of the inner wall of the guide hole) is shifted according to the bend or the defect, so that the lead wire in which an abnormality has occurred can be inserted into the through hole.

In the present embodiment, the detector 100 includes the light projectors 110a and 110b that emit the light beams R₁ and R₂ onto the lead wire of the electronic component E with a lead wire held by the holding unit 68 when the holding unit 68 and the electronic component E with a lead wire held thereby rotate, and the light receivers 112a and 112b that receive the light beams R₁ and R₂ emitted from the light projectors 110a and 110b. According to this configuration, the operation of guiding the lead wire of the electronic component E with a lead wire and inserting it into the through hole 98 can be repeatedly performed in a short time, and at the same time, whether or not there is an abnormality in the lead wire of each electronic component E with a lead wire can be detected.

The holding device 60 used for carrying out the lead wire insertion method according to the present embodiment repeatedly performs the third step and the fourth step by rotating again after holding the plurality of electronic component E with lead wires while rotating, so that the operation of guiding the electronic component E with a lead wire and inserting it into the through hole 98 can be repeatedly performed in a short time. As a result, it is possible to provide the holding device 60 used for carrying out the lead wire insertion method according to the present invention more efficiently without requiring a manual operation.

### (Modification)

In the above embodiment, description is made of the case where the third step of placing the jig 80 on the wiring board 90 is performed after the second step of holding the electronic component E with a lead wire is performed, but the present invention is not limited thereto. That is, after the jig 80 is placed on the wiring board 90, the electronic component E with a lead wire may be held (that is, after the third step is performed, the second step may be performed), or these steps may be performed at the same time.

In the above embodiment, Fig. 2 illustrates the case where the plurality of electronic components E with lead wires held by the holding device 60 have the same size and structure, but the present invention is not limited thereto. That is, the plurality of electronic components with lead wires E may have different sizes or different structures.

In the above embodiment, description is made of the case where the first end effector 18a includes the holding device 60, and the plurality of holding units 68 included in the holding device hold the plurality of electronic components E with lead wires at once to perform the operation repeatedly, but the present invention is not limited thereto. For example, the first end effector 18a may include only one holding unit 68, or may include a plurality of holding units 68 provided so as to protrude from a flat surface. Thereby, the structure of the first end effector 18a can be simplified.

In the above embodiment, description is made of the case where, in the first step, the robot 11 that performs an operation on the electronic component E with a lead wire and the jig 80 is further prepared, and the second to fourth steps are performed using the robot 11, but the present invention is not limited thereto. That is, the second to fourth steps may be performed manually without preparing the robot 11 in the first step. As a result, there is no need to purchase and prepare the robot 11, so that the cost can be reduced when the lead wire insertion method according to the present embodiment is introduced.

In the above embodiment, the detector 100 detects the presence or absence of an abnormality in the lead wire by the rotating operation of the holding device 60, but the present invention is not limited to this case. That is, the detector 100 may be provided at a location different from the holding device 60. At this time, the holding device 60 may be moved to the place where the detector 100 is provided by the first robot hand 13a to detect the presence or absence of an abnormality in the lead wire.

In the above embodiment, description is made of the case where the detector 100 detects the presence or absence of an abnormality such as a bend or a defect of the two lead wires L₁ and L₂ having different axial dimensions, but the present invention is not limited thereto. That is, the detector 100 may detect the presence or absence of an abnormality such as a bend or a defect of four lead wires L₁, L₂, L₃, and L₄ having different axial dimensions, or may detect the presence or absence of an abnormality such as a bend or a defect of other lead wires.

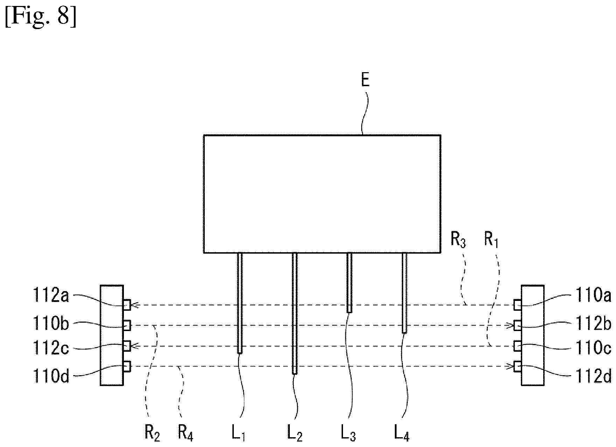

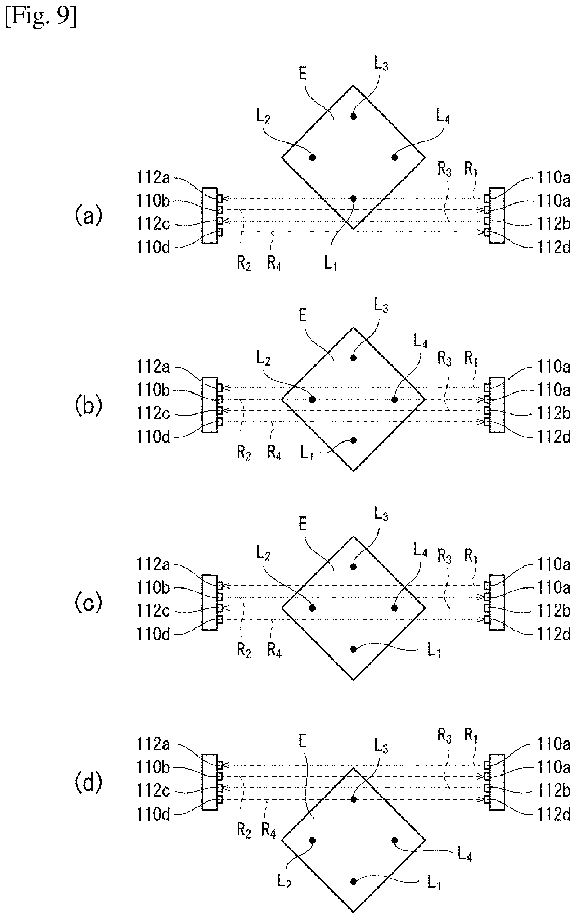

Here, referring to Figs. 8 and 9, description is made of a preferred example of the case where the detector 100 detects the presence or absence of an abnormality such as a bend or a defect of the four lead wires L₁, L₂, L₃, and L₄ having different axial dimensions. Fig. 8 is a side view for explaining a case where the presence or absence of an abnormality of the lead wire is detected by the detector used for carrying out the lead wire insertion method according to a modification of the present invention. Figs. 9 are bottom views for explaining a case where the detector detects the presence or absence of an abnormality in the lead wire, in which Fig. 9(a) is a view when a first light beam is emitted to a first lead wire, Fig. 9(b) is a view when a second light beam is emitted to a second lead wire, Fig. 9(c) is a view when a third light beam is emitted to a third lead wire, and Fig. 4(d) is a view when a fourth light beam is emitted to a fourth lead wire.

The detector 100 detects the presence or absence of an abnormality such as a bend or a defect of the four lead wires L₁, L₂, L₃, and L₄, having different axial dimensions. The detector 100 includes light projectors 110a, 110b, 110c, and 110d that emit light beams R₁, R₂, R₃, and R₄ onto the lead wire of the electronic component E with a lead wire held by the holding device 60 when the holding device 60 described in the above embodiment rotates, and light receivers 112a, 112b, 112c, and 112d that receive the light beams R₁, R₂, R₃, and R₄ emitted from the light projectors 110a, 110b, 11Oc, and 110d. Specifically, the detector 100 includes the first light projector 110a that emits the first light beam R₁ onto the leading end of the lead wire L₁ in the normal state, the first light receiver 112a that receives the first light beam R₁ emitted from the first light projector 110a, the second light projector 110b that emits the second light beam R₂ onto the leading end of the lead wire L₂ in the normal state, the second light receiver 112b that receives the second light beam R₂ emitted from the second light projector 110b, the third light projector 110c that emits the third light beam R₃ onto the leading end of the lead wire L₃ in the normal state, the third light receiver 112c that receives the third light beam R₃ emitted from the third light projector 110c, the fourth light projector 110d that emits the fourth light beam R₄ onto the leading end of the lead wire L₄ in the normal state, and the fourth light receiver 112d that receives the fourth light beam R₄ emitted from the fourth light projector 110d.

Preferably, as shown in Figs. 9, when the electronic component E with a lead wire passing through the detector 100 is viewed from the bottom, a straight line connecting the root portion of the lead wire L₁ and the root portion of the lead wire L₂ is not parallel to the first light beam R₁, the second light beam R₂, the third light beam R₃, and the fourth light beam R₄. More preferably, when the electronic component E with a lead wire is viewed from the bottom, the straight line connecting the root portion of the lead wire L₁ and the root portion of the lead wire L₂ is inclined by about 45 ° with respect to the first light beam R₁, the second light beam R₂, the third light beam R₃, and the fourth light beam R₄. As a result, the timings at which the lead wire L₁ and the lead wire L₂ block the first light beam R₁ are not the same, and similarly, the timings at which the lead wire L₁ and the lead wire L₂ block the second light beam R₂, the third light beam R₃ and the fourth light beam R₄ are not the same. As a result, it is possible to improve the accuracy of detecting an abnormality of a lead wire. The same applies to a straight line connecting the root portion of the lead wire L₃ and the root portion of the lead wire L₄, and the description thereof will not be repeated here.

The detection results by the detector may be accumulated in a computer system (so-called "artificial intelligence (AI)") having a self-learning function for artificially realizing intelligent functions such as inference and judgment. The computer system then controls the robot 11 so as to shift a location against which the leading end of the lead wire is brought into abutment (a part of the inner wall of the guide hole) according to the abnormality of the lead wire (a bend, a defect, or the like) based on the accumulated detection results (for example, what extent the bend or the defect is caused in the lead wire from the normal state), so that the lead wire in which an abnormality has occurred can be inserted into the through hole.

Based on the foregoing description, it is apparent for a person skilled in the art that many modifications and other embodiments may be made to the present invention. Therefore, the foregoing description should be interpreted only as an example and is provided for the purpose of teaching the best mode for carrying out the present invention to a person skilled in the art. The structures and/or functional details may be substantially modified without departing from the spirit of the present invention.

### Reference Signs List

- 11: robot
- 12: base
- 13a, 13b: pair of robot arms
- 14: control device
- 15a, 15b: pair of links
- 16: base shaft
- 17: wrist unit
- 18a: first end effector
- 18b: second end effector
- 19: mechanical interface
- 60: holding device
- 62: disc member
- 64: holding mechanism
- 66: radially extending portion
- 68: holding unit
- 70: connection portion
- 80: jig
- 82: mounting portion
- 84: placing portion
- 88: guide hole
- 90: wiring board
- 98: through hole
- 100: detector
- 110: light projector
- 112: light receiver

## Claims

1. A lead wire insertion method for inserting a lead wire of an electronic component with a lead wire into a through hole formed in a wiring board, the method comprising:
a first step of preparing the electronic component with a lead wire, the wiring board configured so that another electronic component is mounted adjacent to a location where the electronic component with a lead wire is mounted, and a jig having a guide hole for guiding the lead wire to the through hole;
a second step of holding the electronic component with a lead wire;
a third step of placing the jig on the wire board so that one side surface of the jig faces the another electronic component, and a bottom side end of an inner wall of the guide hole of the jig is fitted to the through hole formed in the wiring board; and
a fourth step of causing a leading end of the lead wire to be brought into abutment against the inner wall of the guide hole and to be slid toward the wiring board, and guiding the lead wire of the electronic component with a lead wire to be inserted into the through hole,
wherein the guide hole is opened and formed in the one side surface of the jig so that a cross-sectional area becomes smaller from a top surface to a bottom surface.

2. The lead wire insertion method according to claim 1,
wherein, in the first step, a robot that performs an operation on the electronic component with a lead wire and the jig is further prepared, and
wherein the robot includes:
a first robot arm;
a first end effector that is attached to the first robot arm and performs the second step and the fourth step by performing an operation while holding the electronic component with the lead wire;
a second robot arm; and
a second end effector that is attached to the second robot arm and performs the third step by performing an operation while holding the jig.

3. The lead wire insertion method according to claim 2,
wherein the first end effector includes a holding device that is rotatably provided at a base thereof and holds the electronic component with a lead wire,
wherein the holding device includes a plurality of holding units that each hold one electronic component with a lead wire and are provided radially at intervals in a circumferential direction,
wherein, in the first step, a plurality of electronic components with lead wires are prepared, wherein, in the second step, each of the plurality of holding units is caused to hold a corresponding one of the plurality of electronic components with lead wires, while rotating the holding device, so that the electronic components with lead wires are held,
wherein, in the fourth step, the lead wire of the electronic component with a lead wire is guided and inserted into the through hole, the electronic component with a lead wire being held so as to face the wiring board,
wherein, after the fourth step is performed, the third step of placing the jig on the wire board so that the one side surface of the jig faces the another electronic component or the electronic component with a lead wire on which the fourth step has been already performed, and the bottom side end of the inner wall of the guide hole of the jig is fitted to a next through hole formed in the wiring board is performed again, and the fourth step of guiding a next electronic component with a lead wire among the plurality of electronic components with lead wires and inserting it into the through hole after the holding device is rotated again so that the next electronic component with a lead wire faces the wiring board is performed again, and
wherein the third step is performed again and the fourth step is performed again, which is repeated, so that the operation of guiding the lead wire of the electronic component with a lead wire and inserting it into the through hole are repeatedly performed.

4. The lead wire insertion method according to claim 2 or 3, wherein the holding device further includes detector for detecting whether or not there is an abnormality in each lead wire of the electronic component with a lead wire.

5. The lead wire insertion method according to claim 4, wherein the detector includes:
a light projector that is provided at a base of the first end effector, and emits a light beam onto the lead wire of the electronic component with a lead wire when the holding unit and the electronic component with a lead wire held thereby rotate; and
a light receiver that is provided at the base of the first end effector so as to face the light projector through the holding unit and the electronic component with a lead wire held thereby, and receives the light beam emitted from the light projector.

6. A holding device for holding the electronic component with a lead wire, which is used for carrying out the lead wire insertion method according to claim 2 and is included in the first end effector,
wherein the holding device is rotatably provided at a base of the first end effector,
wherein the holding device includes a plurality of holding units that each hold one electronic component with a lead wire and are provided radially at intervals in a circumferential direction,
wherein, in the first step, the holding device prepares a plurality of electronic components with lead wires,
wherein, in the second step, the holding device causes each of the plurality of holding units to hold a corresponding one of the plurality of electronic components with lead wires, while rotating, so that the electronic components with lead wires prepared in the first step are held,
wherein, in the fourth step, the holding device guides the lead wire of the electronic component with a lead wire to be inserted into the through hole, the electronic component with a lead wire being held so as to face the wiring board
wherein, after performing the fourth step, the holding device performs again the third step of placing the jig on the wire board so that the one side surface of the jig faces the another electronic component or the electronic component with a lead wire on which the fourth step has been already performed, and the bottom side end of the inner wall of the guide hole of the jig is fitted to a next through hole formed in the wiring board, and performs again the fourth step of guiding a next electronic component with a lead wire among the plurality of electronic components with lead wires and inserting it into the through hole after the holding device rotates again so that the next electronic component with a lead wire faces the wiring board, and
wherein the holding device performs again the third step and the fourth step, and repeats these, so that the operation of guiding the lead wire of the electronic component with a lead wire and inserting it into the through hole are repeatedly performed.

7. The holding device according to claim 6, further comprising detector for detecting whether or not there is an abnormality in each lead wire of the electronic component with a lead wire.

8. The holding device according to claim 7, wherein the detector includes:
a light projector that is provided at a base of the first end effector, and emits a light beam onto the lead wire of the electronic component with a lead wire when the holding unit and the electronic component with a lead wire held thereby rotate; and
a light receiver that is provided at the base of the first end effector so as to face the light projector through the holding unit and the electronic component with a lead wire held thereby, and receives the light beam emitted from the light projector.
